# EUROPÄISCHE PATENTANMELDUNG

(11) **EP 4 000 929 A1**
(43) Veröffentlichungstag der Anmeldung: **25.05.2022**
(21) Anmeldenummer: 21208040.2
(22) Anmeldetag: 12.11.2021
(51) Int. Cl.: B33Y 10/00, B22F 10/00, B28B 1/00, C03C 1/00, C04B 35/057, C04B 35/111, C04B 35/14, C04B 35/447, C04B 35/453, C04B 35/486, C04B 35/488, C04B 35/491, C04B 35/50, C04B 35/58, C04B 35/626, C04B 35/638, C04B 38/00, B01J 13/00, G03F 7/00

(54) **GRÜNKÖRPERTROCKNUNGSVERFAHREN FÜR DIE ADDITIVE FERTIGUNG NACH LICHTINDUZIERTEM VERNETZEN VON SUSPENDIERTEN ANORGANISCHEN NANO-PARTIKELN**

(30) Priorität: 12.11.2020 DE 102020129911
(71) Anmelder: Bundesrepublik Deutschland, vertreten durch den Bundesminister für Wirtschaft und Energie, dieser vertreten durch den Präsidenten der, 12205 Berlin (DE)
(72) Erfinder: SÄNGER, Johanna Christiane, 37308 Heilbad Heiligenstadt (DE); GÜNSTER, Jens, 38678 Clausthal-Zellerfeld (DE); MEYER, Frank, 66386 St. Ingbert (DE); GÖBBERT, Christian, 63785 Obernburg am Main (DE)
(74) Vertreter: Zimmermann & Partner Patentanwälte mbB

(57) **Zusammenfassung**

Vorgeschlagen wird ein Additivverfahren zur Herstellung eines filigranen Keramikbauteils, umfassend:
- Bereitstellen eines Arbeitsvolumens eines Kolloids, umfassend kolloidal dispergierte Keramikpartikel eines Durchmessers von 3 bis 100 nm, wobei das Kolloid 0,05 - 20 Gew.-% eines Mehr-Photonenpolymerisationsinitiators, 10 ― 30 Gew.-% polymerisierbares Bindemittel, und 30 - 90 Gew.-% Keramikpartikel, bezogen auf das Gesamtgewicht des Kolloids.umfasst;
- Führen eines Laserfokus im Arbeitsvolumen gemäß eines mit einer Slicing-Software erstellten Datensatzes, der das betreffende filigrane Keramikbauteil repräsentiert;
- lokales Polymerisieren des polymerisierbaren Bindemittels im Laserfokus, wobei das Führen des Laserfokus eine Ausbildung eines Grünkörpers bewirkt,
- Waschen des Grünkörpers in einer Waschflüssigkeit ausgewählt unter Wasser; einem organischen Lösemittel oder einer Mischung von Wasser und einem organischem Lösemittel;
- Austauschen der Waschflüssigkeit durch eine Austauschflüssigkeit, wobei das Austauschen eine kontinuierliche oder eine diskontinuierliche Steigerung einer Konzentration der Austauschflüssigkeit bei einer korrespondierenden Verringerung der Konzentration der Waschflüssigkeit umfasst, bis die Waschflüssigkeit durch die Austauschflüssigkeit ersetzt ist;
- Ersetzen der Austauschflüssigkeit durch wasserfreies flüssiges CO₂, wobei das Ersetzen mindestens 10 Mal erfolgt indem ein zunächst verwendetes Volumen des wasserfreien flüssigen CO₂ durch ein identisches Volumen von wasserfreiem flüssigen CO₂ ersetzt wird, wobei der Grünkörper im wasserfreien flüssigen CO₂ in einem temperierbaren und druckstabilen Behälter angeordnet ist;
- Trocknen des in dem wasserfreien flüssigen CO₂ vorliegenden Grünkörpers mittels einer Kritischen-Punkt-Trocknung;
- Entbindern des getrockneten Grünkörpers durch eine thermische Behandlung; und
- Sintern des Grünkörpers zum filigranen Keramikbauteil.

## Beschreibung

### GEBIET DER ERFINDUNG

Die vorliegende Erfindung betrifft ein Trocknungsverfahren für Grünkörper, die lasergestützt mittels Zwei- oder Mehr-Photonenabsorption (2PP) additiv durch die Vernetzung eines Bindemittels aus kolloidal dispergierten keramischen oder metallischen Nanopartikeln erzeugt werden.

### STAND DER TECHNIK

Vor dem Sintern eines mit einem traditionell mikroskalige Keramikpartikel aufweisenden Schlicker gewonnenen Grünkörpers muss dieser typischerweise schonend getrocknet werden, um eine bei rascher Temperatursteigerung durch potentiell explosionsartig aus Porenräumen austretenden Wasserdampf verursachte Beschädigung, z.B. die Bildung von Rissen und Ausbrüchen, zu vermeiden. Auch aus nanoskaligen Keramikpartikeln generierte, d.h. zusammengesetzte Grünkörper müssen vor dem Sintern getrocknet werden. Die dabei beobachteten Schädigungen filigraner Strukturen, insbesondere Verzerrungen und Bruch sind anscheinend durch andere Mechanismen verursacht, als die eines Grünkörpers, der aus mikroskaligen Keramikpartikeln besteht.

Vor diesem Hintergrund stellt sich die vorliegende Erfindung die Aufgabe, ein schonendes Trocknungsverfahren für nano- und/oder mikrostrukturierte Grünkörper anzugeben.

### ZUSAMMENFASSUNG

Diese Aufgaben werden mit dem Grünkörpertrocknungsverfahren gemäß Anspruch 1, und der Verwendung der Kritischen-Punkt-Trocknung nach Anspruch 8 gelöst. Die von jenen Ansprüchen abhängigen Ansprüche beschreiben weitere vorteilhafte Ausführungsformen der Erfindung.

Das erfindungsgemäße Trocknungsverfahren ermöglicht die additive Herstellung von artifiziellen Keramikbauteilen, d.h. von keramischen Bauteilen mit einer Struktur, die vollständig durch zuvor in einem Steuerprogramm einer technischen Vorrichtung hinterlegte Daten bestimmt ist. Dabei definieren die hinterlegten Daten strukturelle Charakteristika eines Grünkörpers des Bauteils in einer Größenordnung von wenigen Mikrometern bis Millimetern bei einer Auflösung von mehreren Hundert Nanometern bis zu wenigen Mikrometern. Strukturen in dieser Größenordnung werden nachfolgend als "filigran" bezeichnet. Unter Berücksichtigung weiterer Faktoren, beispielsweise einer durch spezifische Sinterbedingungen bedingten Schwindung sind somit strukturelle Charakteristika des keramischen oder metallischen Bauteils in einer Größenordnung von Nanometern bis Millimetern bei einer Auflösung von mehreren Hundert Nanometern bis zu wenigen Mikrometern vorgebbar.

Unter dem Ausdruck "wenigen Nanometern" werden hierbei Durchmesser, Längen, Breiten, Höhen und Tiefen von 2 nm, 3 nm, 4 nm, 5 nm, 6 nm, 7 nm, 8 nm, 9 nm, 10 nm verstanden. Unter den Ausdrücken "Zentimetern" und "wenigen Zentimetern" werden Durchmesser, Längen, Breiten, Höhen und Tiefen von 2 cm, 3 cm, 4 cm, 5 cm, 6 cm, 7 cm, 8 cm, 9 cm, 10 cm verstanden. Unter dem Ausdruck "mehreren Hundert Nanometern" werden Durchmesser, Längen, Breiten, Höhen und Tiefen von 200 nm, 300 nm, 400 nm, 500 nm, 600 nm, 700 nm, 800 nm, 900 nm verstanden. Unter dem Ausdruck "wenigen Mikrometern" werden Durchmesser, Längen, Breiten, Höhen und Tiefen von 1 µm, 2 µm, 3 µm, 4 µm, 5 µm, 6 µm, 7 µm, 8 µm, 9 µm, 10 µm verstanden.

Für die erfindungsgemäß bevorzugten und nachfolgend weiter beschriebenen Suspensionen keramischer Nano-Partikel in/aus denen der Grünkörper mittels 2PP erzeugt wird, wird nachfolgend der Begriff Kolloid verwendet, da dieser geeigneter erscheint, als der Begriff Schlicker, der sonst für technisch einsatzbereite Suspensionen umfassend typischerweise mikroskalige Keramikpartikel gebräuchlich ist. Fachüblich wird auch der Begriff Sol als ein Synonym für das bezeichnete Kolloid gebraucht.

Die Analyse der beim Trocknen mikro- oder nanostrukturierter Grünkörper ablaufender Prozesse führte zu der Erkenntnis, dass ein Verdunsten des Wasseranteils, d.h. die kontinuierliche Verringerung des Volumens des im Grünkörper vorliegenden Wassers - vergleichbar zum fallenden Pegelstand eines austrocknenden Gewässers - ein Wandern der Grenzfläche Flüssigkeit/Gas über und durch den aus Nanopartikeln aufgebauten und also nanoporösen Grünkörper gleicht. Da Wasser gegenüber Luft im Vergleich mit organischen Flüssigkeiten eine vergleichsweise hohe Grenzflächen- bzw. Oberflächenspannung von 72,75 mN/m (bei 20 °C) hat, wirken deshalb während des Trocknens des Grünkörpers ausgeprägte Zugund Scherkräfte auf die vorliegenden Nano- und Mikrostrukturen ein: Die durch die Oberflächenspannung ausgelösten Kräfte, insbesondere die Kapillarkräfte, sind umgekehrt proportional zum Krümmungsradius, sodass für eine nanound/oder mikrostrukturierte geometrisch dichte Packung von Nanopartikeln des Grünkörpers mit einer Packungsdichte, das heißt einem Verhältnis von Partikelvolumen zum Gesamtvolumen des Grünkörpers, beispielsweise von 60 % der spezifischen Dichte des jeweiligen keramischen Feststoffs, die auf eine lokal mit einem Polymernetzwerk fixierte Nanopartikelpackung, also auf den Grünkörper, einwirkenden Kräfte um mehrere Größenordnungen diejenigen Kräfte übersteigen, die für Partikelpackungen zu erwarten sind, welche mit herkömmlichem Schlicker umfassend mikropartikuläre Feststoffe erhalten werden.

Das hier vorgeschlagene, auf einer Trocknung am kritischen Punkt oder in dessen Nähe, beispielsweise oberhalb desselben, eingesetzter Medien (z.B. CO₂) basierende Grünkörpertrocknungsverfahren ist angepasst an die Trocknung von solchen Grünkörpern, die keramische und/oder metallische Nanopartikel aufweisen. Dabei beträgt eine Packungsdichte des Grünkörpers zumindest 40 %, bevorzugt zumindest 50 %, typischerweise zumindest 60% der spezifischen Dichte des entsprechenden Feststoffs - also derjenigen Dichte des jeweiligen Materials (Metall oder Keramik), das im zu trocknenden Grünkörper in Form von agglomerierten Nanopartikeln vorliegt. Weist der zu trocknende Grünkörper Nanopartikel unterschiedlicher stofflicher Natur auf, so beträgt dessen Dichte dementsprechend zumindest 40 %, bevorzugt zumindest 50 %, typischerweise zumindest 60% derjenigen Dichte eines kompakten Feststoffs, dessen Zusammensetzung den jeweiligen Masseanteilen der im Grünkörper vorliegenden Nanopartikel entspricht. Hierbei kommen als nanopartikuläre Feststoffe Aluminiumoxid (Al₂O₃), Siliziumdioxid (SiO₂), Natriumoxid (Na₂O), Calciumoxid (CaO), Phosphorpentoxid (P₂O₅), Bioglas, beta-Tricalciumphosphat (B-TCP), aluminiumoxidverstärkte Zirkonoxidkeramik (ATZ), Titannitrid (TiN), zirkonoxidverstärkte Aluminiumoxidkeramik (ZTA), Calciumcarbonat (CaCO₃), Lithium-Disilikat-Glaskeramik, AP40 Glas, Yttriumoxid Zirkonstabilisiertes Zirkonoxid (TZ-3YS-E), MGB (mesoporous bioactive glass), Ceriumoxid (CeO₂), Zinkoxid (ZnO), Zirkonoxid (ZrO₂), Hydroxylapatit (HA), biphasisches Cacliumphosphat (BCP), Blei-Zirkonat-Titanat (PZT) und Kombinationen daraus in Betracht.

Vor diesem Hintergrund wird mit dem Ziel, die ursprüngliche Struktur des Grünkörpers während eines dem Entbindern und Sintern vorausgehenden Trocknungsschrittes zu erhalten, gemäß einer Ausführungsform die Trocknung des aus Nanopartikeln aufgebauten Grünkörpers mittels Kritischer-Punkt-Trocknung (Critical Point Drying / CPD) vorgeschlagen.

Am kritischen Punkt sind die physikalischen Eigenschaften flüssig und gasförmig nicht existent, sodass es auch keine Phasengrenze gibt. Eine Verbindung kann in ihrem kritischen Punkt, der neben einem Druck und einer Temperatur auch durch eine diskrete Dichte der betreffenden Verbindung definiert ist, direkt in eine superkritische Phase übergehen, ohne dass eine Grenzfläche flüssig/gasförmig auftritt. Mit anderen Worten ausgedrückt, da der kritische Punkt das Ende der Dampfdruckkurve einer Flüssigkeit definiert, können durch die Verwendung der Kritischen-Punkt-Trocknung die von einer sonst wirkenden Oberflächenspannung an einer trocknenden filigranen Feinstruktur verursachten Schäden vermieden werden, eben weil hier keine Oberflächenspannung existiert.

Jedoch bestimmen nicht nur die vorstehend erläuterten äußeren, mit dem hinterlegten Datensatz vorgegebenen Strukturgrößen des Grünkörpers dessen bei traditioneller Trocknung letztlich durch Oberflächenspannungen verursachte Beschädigungen, sondern ebenso die das verwendete Kolloid jeweils charakterisierenden Parameter Partikelgröße, Partikelfracht, Viskosität, Bindemittelkonzentration sowie prozesstechnische Parameter, beispielsweise die apparateseitig vorgegebene Lichtintensität, Fokusweite, Pulsdauer und Schreibgeschwindigkeit und die damit erzielte effektive Größe des Voxels die Größe und Anordnung diskreter Angriffsflächen für die beim traditionellen Trocknen auftretende Grenzflächenkräfte. Somit ist das vorgeschlagene Trocknungsverfahren für mittels Zwei- und/oder Mehrphotonenpolymerisation erzeugte Grünkörper an das ausgewählte Kolloid, insbesondere an die Verwendung von keramischen oder metallischen Nanopartikeln angepasst.

Da der kritische Punkt von Wasser bei 373,95 °C und 220,64 bar liegt, erfordert das Erzeugen des zum Erreichen des kritischen Punktes von Wasser notwendigen Drucks einen erheblichen technischen Aufwand. Hingegen kann erfindungsgemäß der Ersatz des Wasseranteils des Grünkörpers durch (flüssiges) Kohlendioxid, dessen kritischer Punkt bei 30,98°C und 73,77 bar liegt, und das nachfolgende Entfernen des CO₂ im bzw. oberhalb seines kritischen Punktes zu einer zerstörungsfreien Trocknung des Grünkörpers genutzt werden. Da flüssiges CO₂ mit Wasser nicht mischbar ist, also nicht direkt zum Ersatz des zunächst im Grünkörper vorliegenden Wassers verwendet werden kann, wird es erfindungsgemäß durch eine Austauschflüssigkeit ersetzt. Geeignete Austauschflüssigkeiten sind Isopropanol (i-PrOH), Ethanol, Methanol oder Aceton. Diese Lösungsmittel sind sowohl mit Wasser als auch mit flüssigem CO₂ mischbar.

Nach dem Austauschen des Wassers durch die Austauschflüssigkeit in einem vorkritischen Punkt-Trocknungsschritt und dem sich daran anschließenden Schritt des (mehrmaligen) Ersetzens der gewählten Austauschflüssigkeit durch flüssiges CO₂ wird der nun durchweg mit weitestgehend wasserfreiem und austauschflüssigkeitsfreiem flüssigem CO₂ befeuchtete Grünkörper durch Erwärmen und Drucksteigerung in einem geschlossenen und temperierbaren Behälter an den und sodann über den kritischen Punkt des CO₂ gebracht.

Das Phasendiagramm des CO₂ gibt den für die Kritische-Punkt-Trocknung nutzbaren Parameterraum vor. Sollte ein anderes Gas für die kritische Punkttrocknung verwendet werden, beispielsweise ein Freon, so werden für Druck und Temperatur des nutzbaren Parameterraums entsprechend andere Werte aus dem Phasendiagramm des Freons abgeleitet.

Unter den vorstehend verwendeten Ausdrücken "über den kritischen Punkt" und "oberhalb des kritischen Punktes" ist in diesem Zusammenhang ein durch Temperatur und Druck definierter Bereich bezeichnet, an dem "überkritisches CO₂", bzw., beispielsweise, "überkritisches Freon" vorliegt (vgl. Phasendiagramm von CO₂, bzw. des Freons). Nachfolgend wird der Einfachheit halber nur noch der praktisch bedeutsamere Fall einer Kritischen-Punkt-Trocknung unter Verwendung von CO₂ beschrieben.

Sodann wird bei einer konstanten Temperatur, die der Temperatur im kritischen Punkt des CO₂ im Wesentlichen gleicht, CO₂ mit einem definiert eingestellten Volumenstrom aus dem verwendeten Behälter entlassen, wobei die zur Beibehaltung des superkritischen Zustandes des CO₂ erforderlichen Bedingungen - gemäß den aus dem Phasendiagramm bekannten Druck- und Temperatur-Werten solange aufrechterhalten werden, bis das flüssige CO₂ fast vollständig aus dem Behälter abgeströmt ist. Das kann vorteilhaft über die Kontrolle des Druckabfalls an einem Gas-Auslass des Behälters erfolgen. Unter praktischen Bedingungen hat sich ein Druckabfall nicht größer als 0,05 bar je Sekunde bewährt. Ist der Druck im gesamten Arbeitsvolumen auf Atmosphären(normal)druck überführt, liegt der vollständig getrocknete Grünkörper vor. Im Ergebnis dieser Folge von Prozessschritten liegt der Grünkörper vollständig wasserfrei und also getrocknet vor und kann daran anschließend entbindert und gesintert werden.

Gemäß einer Ausführungsform umfasst das vorgeschlagene Trocknungsverfahren für einen filigrane Strukturen aufweisenden Grünkörper somit die folgenden Schritte:
a) Waschen des Grünkörpers mit einer Waschflüssigkeit, umfassend Entfernen von nicht vernetzten Keramikpartikeln, nicht polymerisiertem Bindemittel, Polymerisationsinitiator und Dispersionsmittel des Kolloids;
b) Überführen des Grünkörpers in eine organische Austauschflüssigkeit, diskontinuierlich mittels einer Verdünnungsreihe umfassend mindestens 5 Austauschschritte mit verschiedenen Volumenverhältnissen der Waschflüssigkeit zu einer Austauschflüssigkeit, beispielsweise in Verhältnissen von (v/v) 80:20, 60:40, 40:60, 20:80, 0:100, wobei die eingesetzten Verhältnisse durchaus von den angegebenen Werten abweichen können, beispielsweise um ± 5 oder um ± 10, mit der Maßgabe, dass die Summe der Anteile der Waschflüssigkeit und der Austauschflüssigkeit jeweils 100 % ergibt. Alternativ kann das Dispersionsmittel auch kontinuierlich, beispielsweise durch die Beaufschlagung mit einem Konzentrationsgradienten durch die Austauschflüssigkeit ersetzt werden;
c) Ersetzen der Austauschflüssigkeit durch wasserfreies flüssiges CO₂, wobei dieses Ersetzen der Austauschflüssigkeit in Analogie zum Überführen des Grünkörpers aus dem wässrigen Medium in die Austauschflüssigkeit ebenso mehrfach erfolgt: Das zuerst verwendete Volumen des flüssigen CO₂ wird mehrfach durch weitere Volumina wasserfreien flüssigen Kohlendioxids ersetzt. Insgesamt wird dieses Ersetzen mindestens 10 Mal, bevorzugt mindestens 15 Mal, weiter bevorzugt mindestens 18 Mal vorgenommen. Im Ergebnis dessen liegt der Grünkörper nun in flüssigem CO₂ vor und wird von diesem vollständig umschlossen. Hierbei wird darauf geachtet, dass die umgebende Atmosphäre wasserfrei ist.
d) Trocknen des in flüssigem CO₂ vorliegenden Grünkörpers mittels einer Kritischen-Punkt-Trocknung (CPD), indem das flüssige CO₂ in superkritisches CO₂ überführt wird. Hierzu wird der verwendete Behälter verschlossen und geheizt, sodass die für den kritischen Punkt des CO₂ charakteristischen Druck-und Temperaturwerte erreicht werden.

Zur Herstellung des Grünkörpers mittels Mehrphotonenpolymerisation werden nasschemisch erzeugte oder kommerziell erhältliche Suspensionen vollständig dispergiert vorliegender nanoskaliger Keramikpartikel durch Zugabe eines in dem flüssigen Suspensionsmedium löslichen Monomers, optional zusätzlich eines Vernetzers, und eines entsprechenden Zwei-Photonenpolymerisationsinitiators in ein Kolloid überführt, das nach Polymerisation und/oder Vernetzung des gelösten Monomers eine zuverlässige Fixierung der Keramikpartikel und die Ausbildung eines Grünkörpers in einem mit Laserlicht behandelten Arbeitsvolumen umfassend das eingesetzte Kolloid ermöglicht.

Erhaltene Kolloide werden durch eine Zwei-Photonenabsorption lokal also so verfestigt, dass die Ausbildung filigrane Strukturen aufweisender Grünkörper entsprechender Bauteile ermöglicht wird. Insbesondere werden die im Dispersionsmittel vorliegenden kolloidalen Partikel durch lokal polymerisiertes Bindemittel räumlich unter allmählicher Ausbildung des Grünkörpers fixiert, das Kolloid gewissermaßen eingefroren: Im Kolloid enthaltene Zwei-Photonenpolymerisationsinitiatoren lösen nach entsprechender laserinduzierter Absorption und Radikalbildung eine radikalische Polymerisationsreaktion aus, die zur lokalen Polymerisation des polymerisierbaren Bindemittels im Laserfokus und letztlich zur Ausbildung des Grünkörpers führt, wenn der Laserfokus im Kolloid, das in diesem Zusammenhang synonym als Arbeitsvolumen bezeichnet wird, geführt wird. Das Führen des Laserstrahls, genauer: das Führen seines Fokus, erfolgt dabei gemäß einem mittels einer Slicing-Software erstellten Datensatzes, der das betreffende Bauteil repräsentiert, beispielsweise unter Verwendung eines Spiegelscanners.

Eine kolloidale Flüssigkeit im Sinne der vorliegenden Erfindung weist notwendigerweise Keramikpartikel, insbesondere nanoskalige Keramikpartikel auf. Dabei werden unter nanoskaligen Keramikpartikeln solche mit einem dvso im Bereich 1-100 nm verstanden. Geeignete Kolloide können keramische Nanopartikel bis zu einer Größe von 150 nm aufweisen.

Die keramischen Partikel können ausgewählt sein aus der Gruppe bestehend aus: Al₂O₃, ATZ, CaCO₃, CaO, CeO₂, Hydroxylapatit, Na₂O, P₂O₅, PZT, SiO₂, TiN, TiO₂, B-TCP, Y₂O₃, YSZ, ZnO, ZrO₂, oder PZT und deren Kombinationen. Eine geeignete Lithium-Disilikat-Glaskeramik kann beispielsweise die Glaskeramik VITA Mark II (VITA Zahnfabrik, Bad Säckingen) sein.

Zur Herstellung von nanoskaligem ZrO₂ nach bisher gebräuchlichen Standardverfahren wurde bisher Flammenpyrolyse und Fällung verwendet. Bei der Flammenpyrolyse von Zirkoniumsalzen (gemischt ggf. mit Yttriumsalzen) ist die Partikelgröße des dabei entstandene Materials zwar < 100 nm, jedoch breit verteilt. Das pyrolytisch erhaltene Material lässt sich sehr schlecht dispergieren, da sehr harte und fast nicht aufbrechbare Agglomerate entstehen. Mittels Fällung durch pH-Wert Änderung einer Zirkoniumsalzlösung (gemischt ggf. mit Yttriumsalzen) entsteht ein amorphes Präzipitat. Dieses muss getrocknet und kalziniert werden, bis ein isoliertes nanoskaliges Pulver entsteht. Auch das lässt sich sehr schlecht dispergieren, da sehr harte und fast nicht aufbrechbare Agglomerate durch die Feuerung, die zur Kristallisation notwendig ist, entstehen.

Im Rahmen der hier beschriebenen Arbeiten wurde deshalb zur Herstellung von sehr gut in Wasser und Lösemitteln dispergiertem dotiertem und undotiertem Zirkonoxid, hier als "nano-ZrO₂" bezeichnet, das nachfolgend beschriebene solvothermale Herstellungsverfahren eingesetzt: Ausgehend von einem Zirkoniumalkoholat (z.B. Zirkonium(n)propylat, d.h. Zirkonium(IV)-propoxid, Tetrapropylzirkonat), das in einem Alkohol (bevorzugt n-Propanol) vorliegt, wird eine Sol-Gel Synthese durchgeführt. Es kann auch in Kombination mit einem Yttriumsalz in Wasser zum Fällen des Zirkoniumalkoholats verwendet werden, wenn mit Yttrium dotiertes ZrO₂ erhalten werden soll. Das Zirkoniumalkoholat wird in einem Rührbehälter vorgelegt und mit einer Säure, bevorzugt mit Wasser verdünnte HNO₃, oder mit Wasser (und optional einem Yttriumsalz) unter starkem Rühren hydrolisiert. Das dabei entstehende Gemisch aus Wasser, n-Propanol und amorphem Zirkondioxid (ggf. mit Yttrium) wird anschließend in einem Autoklaven unter Rühren autoklaviert (200-250°C, 20-40 bar, 1-3h) . Es entsteht nanoskaliges (ggf. dotiertes) ZrO₂ in einem Gemisch aus Wasser und Alkohol. Mittels einer Filterpresse wird das erhaltene Gemisch bis auf einen Anteil von zumindest 50 Masse-% ZrO₂ kompaktiert und liegt sodann als feuchter Filterkuchen vor. Dieser Filterkuchen wird mit einer Säure gesumpft (bevorzugt Essigsäure oder 3, 6, 9 - Trioxadecansäure), mit Wasser aufgeschlämmt und mit einer Keramikverkleideten Rührwerkskugelmühle mit ZrO₂ Mahlperlen auf ein D90vol < 80 nm, bevorzugt < 50 nm besonders bevorzugt < 30 nm aufgemahlen. Dabei umfasst die Keramikauskleidung der Rührwerkskugelmühle bevorzugt Zirkoniumoxid oder eine ähnliche Keramik. Es entsteht eine Suspension mit der Viskosität im Bereich von Wasser, die im sichtbaren Bereich und im NIR, also bei der typischerweise eingesetzten Wellenlänge des bei der additiven Fertigung genutzten Lasers nahezu transparent ist.

Die Primärpartikel des nano-ZrO₂ weisen einen Durchmesser < 10 nm auf, sind monoklin und/oder tetragonal und werden wie vorstehend beschrieben suspendiert in Wasser mit 45% Feststoff mit Hilfe eines Dispergators gewonnen. Die Form der Partikel ist rund bzw. nahezu rund, in dispergiertem Zustand sind die Partikel des nano-ZrO₂ zu 99% monodispers, und weisen in dispergiertem Zustand zu weniger als 1 % des Volumens der Dispersion eine Größe (mittels DLS bestimmten mittleren Durchmesser) von > 30 nm auf. Wenn eine Dotierung des nano-ZrO₂ gewünscht ist, so erfolgt diese bevorzugt mit Yttrium, im Bereich von 1 -10 Mol%, bevorzugt von 3-8 Mol%, weiter bevorzugt sind 3 Mol% oder 8 Mol%. Alternativ können zur Dotierung beispielsweise auch Calcium- oder Magnesium-Salze eingesetzt werden. Bevorzugte molare Anteile der Dotierung liegen auch hier im Bereich von 2 Mol% - 8 Mol%, wobei hier die gleichen bevorzugten Bereiche molarer Anteile gelten. Bevorzugt dicht gesinterte Bauteile des in drei Modifikationen (monoklin, tetragonal und kubisch) auftretenden Zirkoniumoxid lassen sich ausschließlich in kubischer und/oder tetragonaler Kristallmodifikation fertigen: Da durch einen Volumensprung beim Überschreiten einer bestimmten Temperatur eine Rissbildung und damit ungünstigenfalls einhergehende Zerstörung der Keramik auftritt, können dem ZrO₂ Stabilisatoren in Form von Dotierungen zugesetzt werden. Vorteilhaft stabilisieren Magnesiumoxid (MgO), Calciumoxid (CaO) oder Yttriumoxid (Y₂O₃) die bevorzugte Kristallmodifikation des Zirkoniumoxid.

Bevorzugt werden Kombinationen aus Al₂O₃, Bioglas und B-TCP, insbesondere Kombinationen aus Al₂O₃, Bioglas 45S5 und B-TCP. Bioglas 45S5 ist kommerziell erhältlich (Vitryxx, Schott AG, Mainz, Deutschland) und setzt sich zusammen aus 45,5 Gew.-% SiO₂, 24,25 Gew.-% CaO, 24,25 Gew.-% Na₂O und 6,0 Gew.-% P₂O₅, bezogen auf das Gesamtgewicht. Diese Kombination haben sich als besonders vorteilhaft in medizinischen und biologischen Anwendungen herausgestellt.

Ferner bevorzugt sind Kombinationen aus Al₂O₃, CeO₂ und ZnO bzw. aus HA und BCP. Diese Kombination haben sich als besonders vorteilhaft in medizinischen und biologischen Anwendungen herausgestellt.

Vorteilhaft sind auch Kombinationen von Keramikpartikeln bestehend aus Al₂O₃ und ZrO₂ oder aus Al₂O₃ und HA. Diese Keramiken zeichnen sich durch besonders hohe Festigkeit für Implantate mit hoher mechanischer Belastbarkeit aus.

Weiter bevorzugte Keramikpartikel sind Kombinationen aus CaCO₃ und AP40 Glas. AP40 Glas besteht aus 44.3 Gew.-% SiO₂, 31.89 Gew.-% CaO, 11.21 Gew.-% P₂O₅, 0.2 Gew.-% K₂O, 4.6 Gew.-% Na₂O, 2.8 Gew.-% MgO, 5.0 Gew.-% CaF₂ bezogen auf sein Gesamtgewicht.

Für die Verwendung von nano-ZrO₂ in der additiven Fertigung von filigranen Keramikbauteilen ist es vorteilhaft, die wie oben beschrieben erhaltene wässrige Suspension in ein Lösemittel z.B. einen Alkohol oder einen Ester umzuarbeiten, in dem zusätzliche Bestandteile (z.B. Photoinitiator und Bindemittel) löslich sind. Bevorzugte Lösemittel sind beispielsweise: Ethanol, n-Propanol, iso-Propanol sowie Methoxypropanol. Dabei wird wie folgt vorgegangen: Zunächst erfolgt ein Abziehen des Wassers durch Abdampfen bzw. Gefriertrocknen bis auf eine Restfeuchte <5%, danach ein Aufschlämmen des getrockneten nano-ZrO₂ in dem gewünschten Lösemittel. Mittels Ultraschall und/oder unter Verwendung eines Attritors und/oder einer Rührwerkskugelmühle kann eine zusätzliche Nachdispergierung vorgenommen werden. Die in einem Lösemittel analog zu Wasser erzielte Partikelgröße des nano-ZrO₂ ist, angegeben als D90vol, in Dispersion < 80 nm, bevorzugt < 50 nm, besonders bevorzugt < 30 nm - gemessen mittels DLS (dynamischer Lichtstreuung) oder PCS (Photonenkorrelations-spektroskopie bzw Laserbeugung). Hierbei ist unter einem D90vol - Wert derjenige Partikeldurchmesser von 90% des kumulativen Volumens zu verstehen. Mithin gibt der D90vol - Wert die volumetrische Menge des Partikeldurchmessers bei 90 % kumulativer Größe an, d.h. 90 Volumenprozent der Partikel sind kleiner als dieser Durchmesser.

Alternativ kann die Umarbeitung des nano-ZrO₂ in ein Lösemittel bzw. Dispersionsmedium mit höherem Siedepunkt als Wasser erfolgen. Hierzu wird dieses der bisher wässrigen Suspension zugesetzt. Danach wird das Wassers abdestilliert, das dispergierte Material verbleibt im neuen hochsiedenden Dispersionsmedium unter Beibehaltung der ursprünglichen Partikelgrößenverteilung, d.h. ohne die Bildung unerwünschter Agglomerate. Mit anderen Worten ausgedrückt, liegt das nano-ZrO₂ als kolloidale Flüssigkeit vor, in der dann weitere, für den 2PP-Prozess erforderliche Komponenten gelöst werden.

Zur Herstellung der erfindungsgemäß zu trocknenden Grünkörper einsetzbare Kolloide umfassen 0,05 - 20 Gew.-% eines Mehr-Photonenpolymerisationsinitiators, wenigstens eines Zwei-Photonenpolymerisationsinitiators, 10 - 30 Gew.-% polymerisierbares Bindemittel, und 30 - 90 Gew.-% Keramikpartikel, bezogen auf das Gesamtgewicht des Kolloids.

Besonders bevorzugt sind hierbei kolloidale Flüssigkeiten umfassend 0,5 - 1 Gew.-% wenigstens eines Zwei-Photonenpolymerisationsinitiators oder eines Mehr-Photonenpolymerisationsinitiators, 20 - 25 Gew.-% polymerisierbares Bindemittel und 70 - 80 Gew.-% anorganische Partikel, insbesondere etwa 75 Gew.-% Keramik- oder Metall-Partikel, bezogen auf das Gesamtgewicht des Kolloids.

Hierbei weisen die jeweils im Kolloid vollständig dispergiert vorliegenden Partikel bevorzugt Durchmesser im Bereich von 3 nm bis < 150 nm auf. Ein weiter bevorzugter Größenbereich des arithmetisch mittleren, mittels dynamischer Lichtstreuung bestimmbaren Durchmessers der Partikel liegt zwischen 2 nm und 100 nm, besonders bevorzugt im Bereich von 2 nm bis 35 nm. Das heißt, dass die erfindungsgemäß kolloidal vorliegenden metallischen oder keramischen Partikel einen dvso - Wert im Bereich 1-100 nm aufweisen. Geeignete Kolloide können mithin metallische oder keramische Nanopartikel bis zu einer Größe von 150 nm aufweisen.

Gemäß der vorliegenden Erfindung wird ein getrockneter, zum Entbindern und Sintern bereitstehender Grünkörper eines metallischen oder eines keramischen Bauteils bereitgestellt, wobei mindestens eine Oberfläche des Bauteils Strukturen in einer Größenordnung von weniger als 10 µm aufweist. Ein Grünkörper kann z.B. eine maximale Ausdehnung von 100 µm x 100 µm x 100 µm aufweisen und Poren von 5 µm -10 µm aufweisen.

Unter Berücksichtigung einer beim Sintern auftretenden Schwindung weist mindestens eine Oberfläche des Grünkörpers Strukturen in einer Größenordnung von 1-5 µm auf. Besonders bevorzugt lassen sich erfindungsgemäß Grünkörper umfassend keramische Nanopartikel zerstörungsfrei trocken, die mindestens eine Oberfläche umfassend Strukturen in einer Größenordnung von 0,1-1 µm aufweisen.

### KURZE BESCHREIBUNG DER FIGUREN

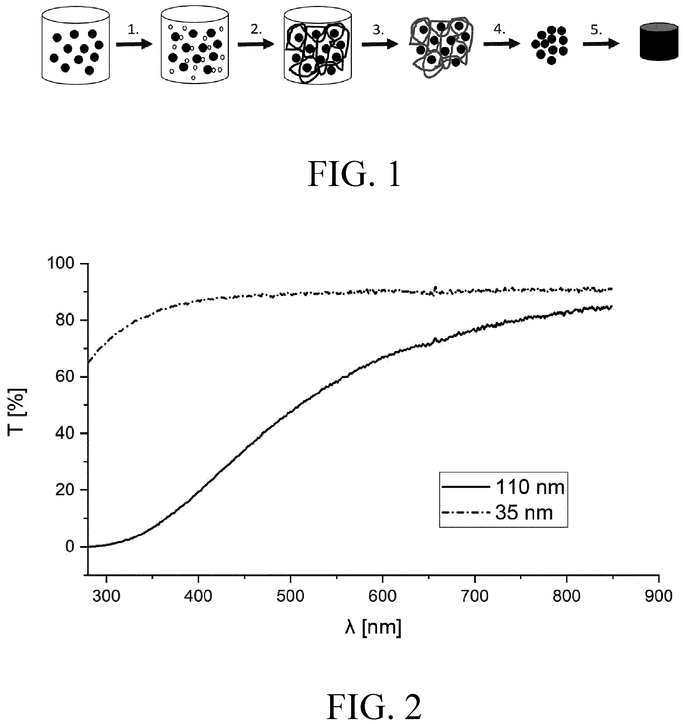

In den beigefügten Zeichnungen zeigt bzw. zeigen
**Fig. 1** die Abfolge technologischer Prozessschritte ausgehend von einem Kolloid keramischer Nanopartikel.
**Fig.2** die Transmission (T) von dispergierten keramischen Partikeln gleicher stofflicher Zusammensetzung aber unterschiedlicher Größe in reinem Dispersionsmedium.
**Fig. 3** die Oberfläche eines beispielhaft als Modell gewählten Bauteiles.
**Fig. 4** eine Rasterelektronenmikroskop (REM)-Aufnahme einer gesinterten Modellstruktur auf einem kollabierten Sockel.
**Fign. 5, 6** REM-Aufnahmen einer gesinterten kollabierten Modellstruktur, ihre Trocknung erfolgte konventionell an der Luft
**Fign. 7, 8** REM-Aufnahmen einer Aufnahme einer gesinterten gebrochenen Modellstruktur.
**Fign. 9, 10** REM-Aufnahmen einer gemäß dem vorgeschlagenen Verfahren hergestellten Modellstruktur, vor dem Sintern mit CO₂-Kritischer-Punkt-Trocknung getrocknet.
**Fig. 11** REM-Aufnahmen desselben Details aus Fig. 10. Oben rechts mittels Sekundärelektronen und unten rechts mittels zurückgestreuter Elektronen aufgenommen. Dazu die jeweiligen EDX-Spektren der im Rückstreubild unterschiedlich intensiven Regionen.

### DETAILLIERTE BESCHREIBUNG

Die vorliegende Erfindung stellt ein Verfahren zur Herstellung von Keramikbauteilen, insbesondere von Nano- und/oder Mikrostrukturen aufweisenden Keramikbauteilen mittels Mehr- bzw. Zwei-Photonenpolymerisation bereit. Ferner stellt die vorliegende Erfindung geeignete Kolloide für die Mehr bzw.-Zwei-Photonenpolymerisation und ein Trocknungsverfahren für daraus mittels Mehrphotonenpolymerisation gewonnene Grünkörper zur Verfügung.

Ein, beispielsweise, mittels dynamischer Lichtstreuung (DLS) (z.B. mit Hilfe eines Zetasizer Nano ZS / Malvern) bestimmbarer Durchmesser der dabei als sphärisch angenommenen Keramikpartikel des Kolloids liegt in einem Bereich von 3-150 nm, bevorzugt in einem Bereich von 3-100 nm, weiter bevorzugt in einem Bereich von 3-80 nm.

Die die Keramikpartikel umfassende Suspension, ein aus den Keramikpartikeln gebildetes Sol bzw. das dispergierte Keramikpartikel enthaltende Kolloid ist frei von Agglomeraten, sodass die bezeichnete maximale Partikelgröße von 150 nm nicht überschritten wird. Die Begriffe Schlicker, Suspension, Sol und Kolloid werden in der vorliegenden Anmeldung als Synonyme gebraucht.

Zum hier beschriebenen Zweck der Herstellung von mikrostrukturierten Keramikbauteilen können die zu deren Herstellung verwendeten Kolloide ein organisches Bindemittel, einen Vernetzer, ein Lösungsmittel, einen Stabilisator, einen Inhibitor und/oder ein Dispergiermittel aufweisen. Dispergiermittel verhindern die Bildung von Agglomeraten sowie das Sedimentieren der Keramikpartikel. Stabilisatoren und Inhibitoren verhindern ein spontane Polymerisation. Die Zahl der hier und im übrigen Text und den Ansprüchen mit den unbestimmten Artikeln "ein/einen" versehenen Komponenten ist dabei nicht auf jeweils eine einzige Komponente beschränkt, sondern wird synonym für "mindestens ein/e" verwendet. Das die Elemente der vorstehenden Aufzählung verknüpfende "und/oder" bezeichnet, wie auch in anderen Listen der vorliegenden Beschreibung und Ansprüche, die Möglichkeit, dass ein Element oder mehrere Elemente optional auch nicht vorliegen können bzw. müssen, um das jeweils beschriebene Ergebnis zu erhalten.

Die erfindungsgemäßen Kolloide können weitere Additive enthalten, wie beispielsweise ein Entschäumungsmittel, einen Entbinderungsbeschleuniger und/oder ein Hautverhinderungsmittel.

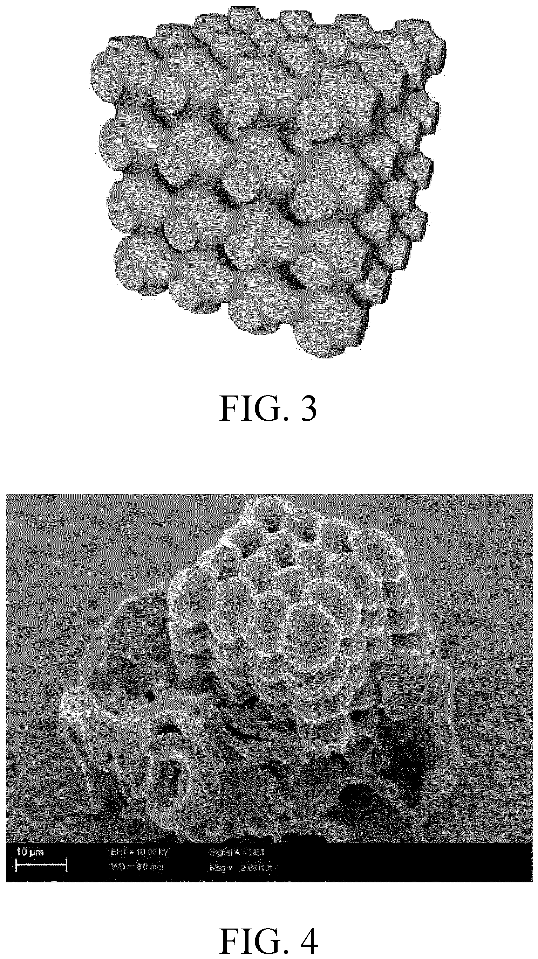

Die **Fig. 3** zeigt die Oberfläche eines beispielhaft als Modell gewählten Bauteiles, insbesondere das Modell einer dreifach-periodischen Minimal-Oberfläche, die sogenannte P-Oberfläche. Diese Fläche ist darstellbar gemäß (cos(x)+cos(y)+cos(z)=0), und wurde - mit unterschiedlichen Kantenlängen - über ein entsprechendes STL-file zur Erzeugung von Steuerdaten eines Lasers genutzt.

Die **Fig. 4** zeigt eine gesinterte Modellstruktur, die mittels Mehrphotonen-Polymerisation aus einem erfindungsgemäßen Kolloid hergestellt wurde und zur Schrumpfminderung auf einem Sockel platziert wurde, wobei der Sockel während der Trocknungs-, Entbinderungs- und Sinterschritte kollabierte. Die Struktur auf dem Sockel hingegen ist nicht direkt am Untergrund befestigt und konnte dadurch gleichmäßig schrumpfen und wurde somit nicht verzerrt.

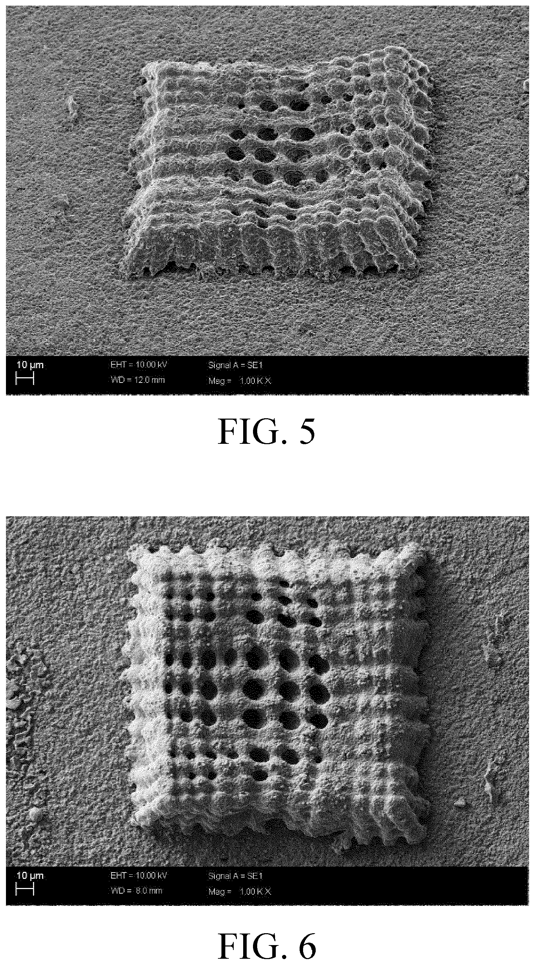

Die **Fign. 5 und 6** zeigen REM-Aufnahmen einer gesinterten kollabierten Modellstruktur in der Draufsicht und unter einem 45°-Winkel, die mittels Mehrphotonen-Polymerisation aus einem erfindungsgemäßen Kolloid hergestellt wurde, jedoch durch unzureichende Trocknung noch vor dem Sintern kollabierte und verzerrt gesintert wurde. Die durch die SchwarzP-Struktur gegebene Porosität ist teilweise nicht vorhanden und unregelmäßig.

Es erwies sich, dass offenbar die während einer herkömmlichen Trocknung der Grünkörper beim Verdunsten des Wassers auftretenden Kapillarkräfte und Oberflächenspannung während des Trocknens zum Kollabieren der filigranen Strukturen führen. Diese Effekte treten unregelmäßig und graduell von außen nach innen auf und verzerren dadurch die Struktur. Zusätzlich schrumpft die Struktur unregelmäßig. Während Bereiche, die am Substrat anhaften, nicht lateral schrumpfen können, tun dies die freiliegenden Bereiche, wodurch eine zusätzliche Verzerrung auftritt.

Die erfindungsgemäß genutzte Kritische-Punkt-Trocknung (CPD) verhindert eine Verzerrung durch Kapillarkräfte und Oberflächenspannung, sodass die Integrität der Struktur gewahrt werden kann. Lediglich die Schwindung durch den Materialverlust, zunächst von Wasser während der Trocknung des organischen Binders während der Entbinderung und durch die Schwindung während des Sinterns, die am Substrat und im Volumen unterschiedliche Effekte hat, muss berücksichtigt werden.

Vorteilhaft wird als Austauschmedium für die CPD Isopropanol verwendet, da das besonders gut sowohl mit Wasser als auch mit flüssigem CO₂ mischbar ist. Jedoch können auch andere Alkohole und Ketone verwendet werden, wie beispielsweise Methanol, Ethanol und Aceton.

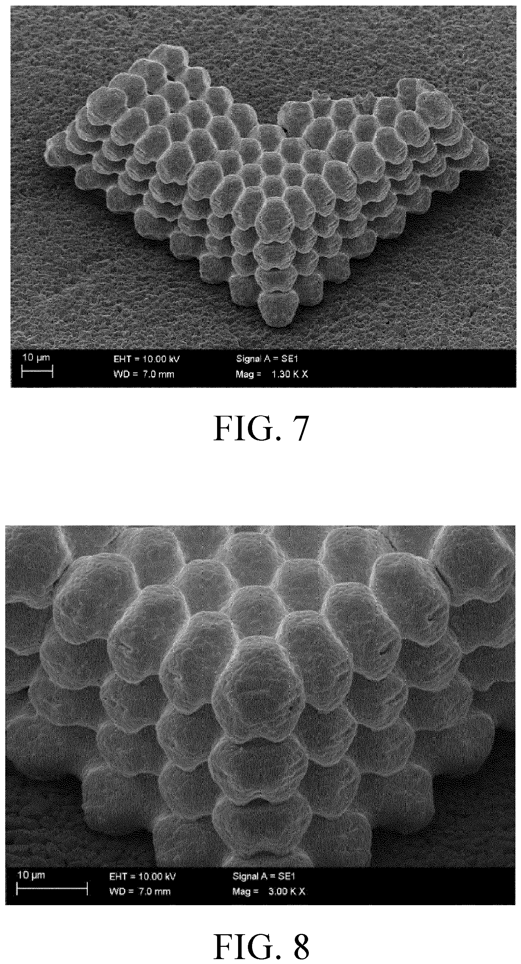

Die **Fign. 7 und 8** zeigen REM-Aufnahmen einer Modellstruktur, die mittels Mehrphotonenpolymerisation eines erfindungsgemäßen Kolloids hergestellt wurde und erst nach dem Durchlaufen einer Kritischen-Punkt-Trocknung gesintert wurde. Die Struktur zeigt lediglich eine Verzerrung durch den Masseverlust und Schwund, aber die Integrität des Modells ist konserviert. Durch das hier vollzogene blockweise Erzeugen mehrerer Untereinheiten der größeren Zielstruktur, wobei der Überlapp während des Schreibprozesses mit 1µm zwischen den Einzelstrukturen definiert ist und die entstehende zeitliche Differenz und Ungenauigkeiten in der Positionierung unwillentlich während des Druckprozesses zu Defekten bzw. Sollbruchstellen führen, die während der Schritte Entbindern und Sintern unter der Wirkung dabei auftretender Spannungen aufbrechen.

In den Fign. 7 und 8 sind die so ungewollt erzeugten "Sollbruchstellen" als Risse zwischen einzelnen sequentiell als gesonderte Untereinheiten gedruckten "Blöcken" erkennbar. Die Ausbildung derartiger als Sollbruchstellen wirkenden Defekte wurde mutmaßlich durch das hier praktizierte überlappende Drucken mehrerer Untereinheiten der Zielstruktur ausgelöst. Beim kontinuierlichen Schreiben der gesamten Struktur kann das Auftreten dieser effektiv als Sollbruchstellen wirkenden Defekte vermieden werden.

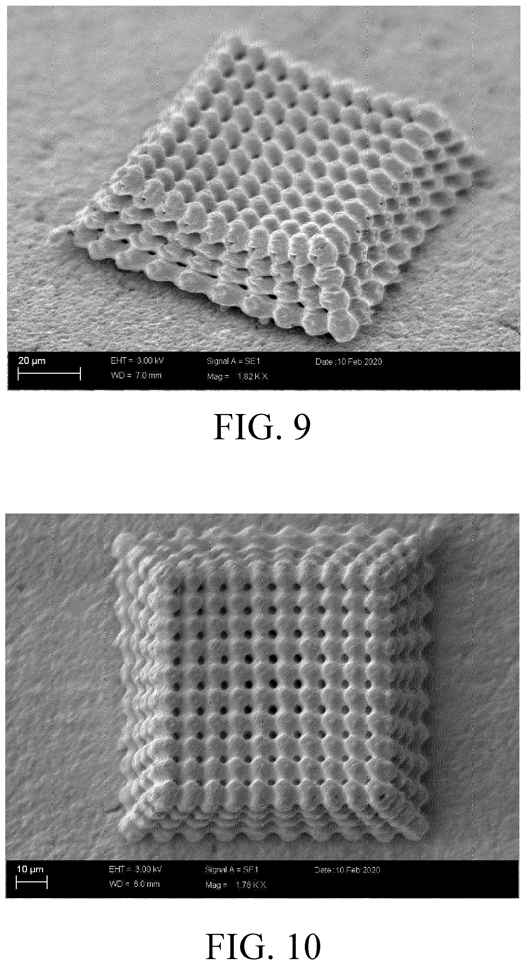

Die **Fign. 9 und 10** zeigen REM-Aufnahmen einer Modellstruktur, die mittels Mehrphotonenpolymerisation eines erfindungsgemäßen Kolloids hergestellt wurde, erst nach Waschschritten und dem anschließenden Durchlaufen einer Kritischen-Punkt-Trocknung gesintert wurde. Hierbei wurden die 12 einzelnen Modelle der Untereinheiten der Zielstruktur vor dem Drucken zu einer einzigen STL-Datei zusammengefügt, wodurch ein kontinuierlicher Druckprozess gewährleistet war. Somit kann die Ausbildung von Unregelmäßigkeiten und von Sollbruchstellen verhindert werden und die Integrität der Struktur durch den Einsatz der CPD gewahrt werden. Der Vergleich der Fign. 5 und 9 verdeutlicht den vorteilhaften Einfluss der Kritisch-Punkt-Trocknung auf das Sinterergebnis.

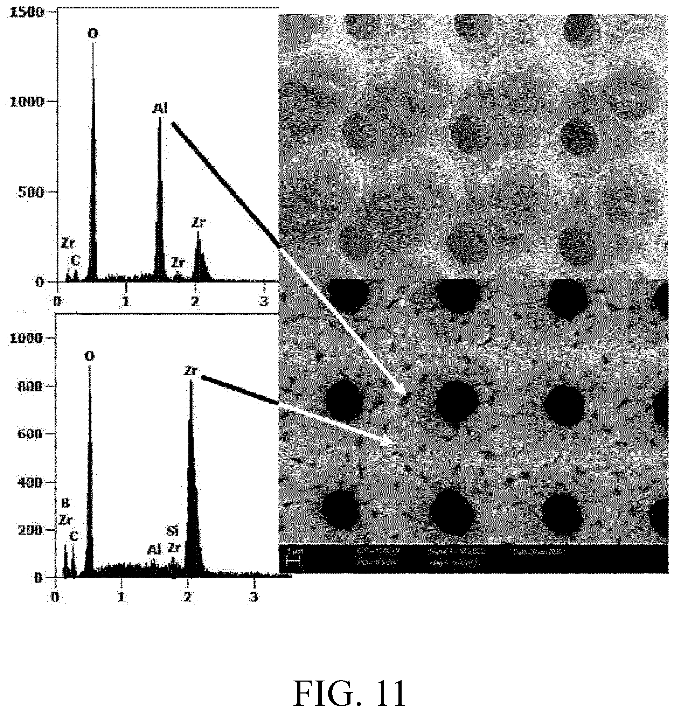

**Fig. 11** zeigt zwei REM-Aufnahmen desselben Details aus Fig. 10. Die Aufnahme oben rechts wurde unter Nutzung der Signale emittierter Sekundärelektronen und unten rechts unter Nutzung der Signale rückgestreuter Elektronen aufgenommen. Das Rückstreubild zeigt mit unterschiedlich intensiven Regionen eine unterschiedliche atomare Zusammensetzung, da die Intensität der zurückgestreuten Elektronen von der Ordnungszahl der Atome abhängig ist, wobei Elemente mit höherer Ordnungszahl intensiver zurückstreuen. EDX (Energiedispersive Röntgenspektroskopie) - Spektren der beiden Regionen zeigen hauptsächlich Aluminium (Ordnungszahl Al = 13) in den dunkel wiedergegebenen Regionen und hauptsächlich Zirkonium (Ordnungszahl Zr = 40) in den hell erscheinenden Regionen. In beiden Regionen ist Sauerstoff nachweisbar, was auf die keramischen Spezies Aluminiumoxid (Al₂O₃) und Zirkonoxid (ZrO₂) schließen lässt.

Um die polymerisierte Struktur mit darin eingebetteten Partikeln von unpolymerisiertem Material (Bindemittel) zu befreien, muss diese mit dem entsprechenden Medium (Wasser oder einem organischen Lösemittel) gewaschen werden. Dazu wird die Bauplattform in die zum Waschen gewählte Flüssigkeit getaucht und verbleibt in diesem typischerweise 12 Stunden.

Daran schließen sich weitere Waschschritte an, wobei die Waschflüssigkeit sukzessive durch ein Austauschmedium, beispielsweise i-PrOH, Aceton oder Ethanol ersetzt wird. Beispielsweise werden Waschschritte in einer Verdünnungsreihe von Wasser mit i-PrOH in Volumenverhältnissen (v/v) von 80:20, 60:40, 40:60, 20:80 und 0:100 vorgenommen, wobei bei jedem Waschschritt die Plattform mindestens 1 Stunde im jeweiligen Gemisch verweilt, bis der Grünkörper in wasserfreies i-PrOH überführt ist.

Daran schließt - wie bereits oben beschrieben - die Kritische-Punkt-Trocknung an, beispielsweise unter Verwendung eines Leica EM CPD300. Zunächst wird in mindestens 18 aufeinanderfolgende Zyklen das Austauschmedium durch flüssiges CO₂ ersetzt. Anschließend werden Druck und Temperatur in dem zur Kritischen-Punkt-Trocknung verwendeten temperierbaren Behälter über den kritischen Punkt von CO₂ (31 °C und 73,8 bar) hinaus geregelt. Um die Trocknung einzuleiten, wird bei konstantem Druck und Temperatur über einen konstanten Volumenstrom von 10 ml/sec das gasförmige CO₂ abgeleitet. Die gezielte Kontrolle des Volumenstroms des aus dem Behälter abgeführten CO₂ bietet hierbei den Vorteil, dass die für die Beibehaltung des superkritischen Zustand des CO₂ erforderlichen Bedingungen solange beibehalten werden, bis zum vollständigen Verbrauch des superkritischen CO₂ im Behälter und die Temperatur der vorgegebenen kritischen Temperatur entspricht oder über dieser liegt. Technologisch vorteilhaft, weil kein teurer Massenflussregler erforderlich ist, erwies es sich, den Druck dabei nur allmählich abzusenken (maximal um 0,05 bar/sec), bis das CO₂ vollständig abgeleitet ist.

Über den Volumenstrom die Trocknung zu kontrollieren nicht über Druckabfall, erlaubt grundsätzlich eine schnellere und kontrolliertere Trocknung des Bauteils, da sich das System automatisch im kritischen Punkt hält solange noch CO₂ da ist und die Temperatur hoch genug ist.

Mit anderen Worten ausgedrückt, wird gemäß einem praktischen Ausführungsbeispiel die dem Arbeitsvolumen entnommene Bauplattform, auf der die mittels 2PP fixierten Bauteile (Grünkörper) jeweils an ihrer Unterseite fixiert sind, einer Waschprozedur unterzogen. Ziel der Waschprozedur ist es, die Grünkörper umfassend das polymerisierte Bindemittel und die vom polymerisierten Bindemittel fixierte Keramikpartikel schonend aus einem wässrigen Medium in ein organisches (Austausch-)Medium, insbesondere in ein organisches Lösungsmittel das zur kritischen Punkt-Trocknung (CPD) verwendet werden soll, beispielsweise in i-PrOH, Ethanol oder Aceton zu überführen. Dazu wird die Bauplattform zunächst oberflächlich vom verwendeten Kolloid mit Wasser gereinigt und verbleibt dazu vorteilhaft mindestens 12 h in Wasser. Anschließend wird, beispielsweise bei Auswahl von i-PrOH als Austauschfluid, die Bauplattform mit den darauf fixierten Grünkörpern mit Hilfe einer Verdünnungsreihe in wasserfreies i-PrOH überführt. Dazu wird der Grünkörper für jeweils eine Stunde in Mischungen von Wasser: i-PrOH (v/v) 80:20, 60:40, 40:60, 20:80 und 0:100 (entsprechend 100 %-igem i-PrOH) inkubiert. Sodann wird die Bauplattform mit den Grünkörpern in wasserfreiem i-PrOH im Probenbehälter einer CPD-Apparatur (z. B. Leica EM CPD300), der mit dem wasserfreien Austauschfluid, also i-PrOH p.a. gefüllt ist, überführt. Hieran schließen sich typischerweise mindestens 18 Spülschritte an, in deren Ergebnis das i-PrOH durch flüssiges CO₂ vollständig ausgetauscht ist. Anschließend werden Druck und Temperatur über den kritischen Punkt von CO₂ (31 °C und 73,8 bar) hinaus geregelt. Um die Trocknung einzuleiten, wird bei konstanter Temperatur von 31 °C (der kritischen Temperatur des CO₂) der Druck langsam auf Umgebungsdruck gesenkt. Hierbei wird der Druck typischerweise um maximal 0,05 bar/sec gesenkt, bis das CO₂ vollständig abgeleitet ist.

Der so mithilfe der Mehr- bzw. Zwei-Photonenpolymerisation hergestellte und mittels CPD getrocknete Grünkörper wird anschließend entbindert und gesintert, um das gewünschte dreidimensionale Bauteil zu erhalten.

"Entbindern" im Sinne der vorliegenden Erfindung bedeutet das Austreiben des polymerisierten Bindemittels. Dies erfolgt bevorzugt durch thermische Behandlung bei ca. 90°C bis 600°C, typischerweise bei einer Temperatur < 650 °C.

"Sintern" bedeutet in diesem Zusammenhang die Verdichtung und Verfestigung der durch Mehrphotonen- oder Zweiphotonenpolymerisation fixierten Partikel des Grünkörpers, bzw. im weitesten Sinne das Verfestigen eines lose gefügten Keramikpulvers oder Metallpulvers im Sinterofen durch Temperatureinwirkung unterhalb der Schmelztemperatur des betreffenden Materials, wodurch der Grünkörper - bedingt durch die Schrumpfung des Polymernetzwerkes - typischerweise schrumpft und seine Festigkeit zunimmt.

Beispielhafte Anwendungsbereiche der hier beschriebene CPD sind Mehr- bzw. Zwei-Photonenpolymerisations-basierte Verfahren der Herstellung dreidimensionaler Keramikbauteile die zur Knochenrekonstruktion bzw. Osteosynthese, der Erzeugung bioverträglicher Zellträgerstrukturen, die Mikrooptik, die Mikroaktorik, die Mikrofluidik (Mikropumpen und -ventile) und die Mikromechanik dienen.

### Bauteile

Bauteile gemäß der vorliegenden Erfindung, insbesondere Keramikbauteile die unter Verwendung des erfindungsgemäßen Trocknungsverfahrens erhältlich sind, können vorzugsweise Implantate, Piezo-Aktuatoren oder freibewegliche Mikromechaniken umfassen.

In diesem Zusammenhang ist ein "Implantat" ein im Körper eingepflanztes oder außen am Körper angebrachtes künstliches Element, welches dauerhaft (für die zu erwartende Lebenszeit des betreffenden Lebewesens) oder zumindest langfristig (zumindest über einen Zeitraum von 5 bis 10 Jahren) dort verbleiben soll. Vom Begriff umfasst sind Endo- und Exoprothesen sowie medizinische, plastische und funktionelle Implantate.

Die vorliegende Erfindung stellt ein hinsichtlich gewünschter Bauteileigenschaften flexibles Herstellungsverfahren individualisierter dreidimensionaler Keramikbauteile, medizinisch nutzbarer Strukturen oder auf die Bedürfnisse von Patienten abgestimmter Implantate bereit. Ebenso können in einem Mikrosystem frei bewegliche mikromechanische Bauteile, die besonders präzise z.B. für Mikroreaktoren einsetzbar sind, sowie Piezo-Aktuatoren für Mikroventile mit besonders hoher Genauigkeit, Stabilität und Reproduzierbarkeit hergestellt werden.

Die erfindungsgemäßen Bauteile, beispielsweise Keramikstrukturen, zeichnen sich sowohl durch hohe Stabilität sowie vorteilhafte Biokompatibilität aus.

Aspekte der vorliegenden Erfindung werden nachfolgend zusammengefasst:
Gemäß einer Ausführungsform wird ein Grünkörpertrocknungsverfahren vorgeschlagen, das mehrere Prozessschritte umfasst:
Insbesondere ein Waschen des Grünkörpers in einer Waschflüssigkeit, sodass Reste von zur Herstellung des Grünkörpers verwendeten Komponenten umfassend nicht verfestigte Nanopartikel und nicht polymerisiertes Bindemittel entfernt werden und/oder Reste eines Suspensionsmediums der verwendeten Komponenten durch die Waschflüssigkeit ersetzt werden.

Weiter umfasst das vorgeschlagene Grünkörpertrocknungsverfahren ein Austauschen der Waschflüssigkeit durch eine Austauschflüssigkeit, wobei das Austauschen eine kontinuierliche oder eine diskontinuierliche Steigerung einer Konzentration der Austauschflüssigkeit bei einer korrespondierenden Verringerung der Konzentration der Waschflüssigkeit umfasst, bis die Waschflüssigkeit durch die Austauschflüssigkeit ersetzt ist.

An das Austauschen schließt sich ein Trocknen des in die Austauschflüssigkeit überführten Grünkörpers mittels einer Kritischen-Punkt-Trocknung mit CO₂ an, wobei die den Grünkörper umschließende Austauschflüssigkeit mindestens 10 Mal, bevorzugt mindestens 15 Mal, weiter bevorzugt mindestens 18 Mal durch jeweils zuvor nicht in Kontakt mit der Austauschflüssigkeit stehendes flüssiges CO₂ ersetzt wird und eine die Kritische-Punkt-Trocknung umfassende Verringerung eines Umgebungsdruckes, dem der im CO₂ vorliegende Grünkörper ausgesetzt ist, vor Abschluss der Kritischen-Punkt-Trocknung 0,05 bar/sec nicht übersteigt.

Vorteilhaft erlaubt der auf Diffusion basierende Austausch ein vollständiges Entfernen der Austauschflüssigkeit. Je weniger Austauschflüssigkeit vor dem Erreichen des kritischen Punktes von CO₂ vorhanden ist, desto vollständiger ist die endgültig erzielte Trocknung. Zudem erfolgt der Übergang von superkritischem CO₂ zu flüssigem CO₂ und letztlich gasförmigem CO₂ schonend.

Gemäß einer Ausführungsform erfolgt das Austauschen diskontinuierlich unter Verwendung einer Verdünnungsreihe umfassend mindestens 5 Austauschschritte mit verschiedenen Volumenverhältnissen der Waschflüssigkeit zu der Austauschflüssigkeit. Beispielsweise kann das in Verhältnissen von (v/v) 80:20, 60:40, 40:60, 20:80, 0:100 erfolgen, wobei die eingesetzten Verhältnisse von den angegebenen Werten auch abweichen können. Beispielsweise um ± 5 oder um ± 10 Volumenteile, mit der Maßgabe, dass die Summe von Anteilen der Waschflüssigkeit und der Austauschflüssigkeit jeweils 100 % ergibt.

Vorteilhaft ersetzt die Austauschflüssigkeit die Waschflüssigkeit zu 100% und stellt somit die anschließende Kritisch-Punkt-Trocknung sicher.

Gemäß einer Ausführungsform des vorgeschlagenen Grünkörpertrocknungsverfahrens wird die Waschflüssigkeit kontinuierlich durch die Austauschflüssigkeit ersetzt, indem eine Konzentration der Austauschflüssigkeit kontinuierlich bis auf 100 vol-% gesteigert wird.

Sich daraus ergebende Vorteile wurden vorstehend bereits beschrieben.

Gemäß einer Ausführungsform dient die Austauschflüssigkeit zumindest teilweise als Waschflüssigkeit und/oder ersetzt diese zumindest teilweise.

Vorteilhaft kann dadurch die Waschzeit vor dem sukzessiven oder kontinuierlichen Zuführen der Austauschflüssigkeit verkürzt werden, da auch diese Vorgänge zu Gunsten der Diffusion mit Warte-/Haltezeiten versehen sind, die das Auswaschen nicht polymerisierter Binder und Reste von nicht verfestigten, d.h. nicht durch Bindemittel fixierten Nanopartikeln befördern.

Gemäß einer Ausführungsform umfasst der Grünkörper keramische oder metallische Nanopartikel, die einen arithmetisch mittleren Durchmesser im Bereich von 3 nm bis 150 nm aufweisen. Bevorzugt weisen die kolloidal dispergierten Partikel Durchmesser von 3 bis 100 nm, weiter bevorzugt von 3 bis 80 nm, besonders bevorzugt von 3 bis 35 nm auf. Wie vorstehend bereits erläutert kann der mittels dynamischer Lichtstreuung ermittelbare dvso-Wert zur Auswahl geeigneter Partikel herangezogen werden. Ebenso können Größen der Partikel mit anderen Techniken, beispielsweise mittels Elektronenmikroskopie bestimmt werden.

Vorteilhaft sind beispielsweise Keramikpartikel unterhalb 80 nm geeignet, da unterhalb dieses Wertes die Rayleigh-Streuung, z.B. für eine Lichtquelle mit einer Wellenlänge von 800 nm, verschwindet und die Suspension trotz der Gegenwart der festen Keramikpartikel optisch transparent ist. Das ermöglicht vorteilhaft ein verlustloses Eindringen der Laserstrahlung in das Arbeitsvolumen bzw. Polymerisation des Binders im Laserfokus und Ausbilden des Grünkörpers.

Gemäß einer Ausführungsform sind keramischen Nanopartikel ausgewählt aus der Gruppe bestehend aus: Aluminiumoxid (Al₂O₃); Siliziumdioxid (SiO₂); Natriumoxid (Na₂O), Calciumoxid (CaO); Phosphorpentoxid (P₂O₅); einem Bioglas; beta-Tricalciumphosphat (B-TCP); einer aluminiumoxidverstärkten Zirkonoxidkeramik (ATZ); Titannitrid (TiN); Calciumcarbonat (CaCO₃); einer Lithium-Disilikat-Glaskeramik; AP40 Glas; einem yttriumoxidstabilisiertem Zirkonoxid (YSZ); einem mesoporösen bioaktiven Glas (MGB); Ceriumoxid (CeO₂); Zinkoxid (ZnO); Zirkonoxid (ZrO₂); Hydroxylapatit (HA); biphasischem Calciumphosphat (BCP); und Blei-Zirkonat-Titanat (PZT).

Vorteilhaft werden keramischen Nano-Suspensionen als Partikelquelle verwendet, weil in diesen die Partikel homogen suspendiert und frei von Agglomeraten vorliegen.

Gemäß einer Ausführungsform sind die Partikel ausgewählt unter metallischen Partikeln oder unter Metalloxid-Partikeln, beispielsweise Gold, Silber oder Eisenoxid, und anderen anorganischen Partikeln, wie beispielsweise Quantenpunkten umfassend Elemente der I., III. und/oder der V Hauptgruppe des Periodensystems der Elemente oder Lanthanide.

Gemäß einer Ausführungsform ist die Austauschflüssigkeit ausgewählt unter einem Keton und einem Alkohol, insbesondere unter Aceton, Ethanol, Methanol, und iso-Propanol.

Vorteilhaft werden Ethanol oder iso-Propanol verwendet, weil diese besonders gut sowohl mit Wasser als auch mit flüssigem CO₂ mischbar sind und darüber hinaus sich auch als Waschflüssigkeiten zur Entfernung nicht polymerisiertem Bindermaterials eignen.

Gemäß einer Ausführungsform wird vorgeschlagen, für das Trocknen eines keramischen oder eines metallischen oder eines metalloxidischen Grünkörpers, umfassend ein polymerisiertes Bindemittel und entsprechende Nanopartikel der bezeichneten Materialien eine Kritische-Punkt-Trocknung zu verwenden, wobei der zu trocknende Grünkörper zumindest eine Struktur umfasst, die eine lineare Ausdehnung ≤ 10 µm, vorzugsweise von 1 bis 5 µm, besonders bevorzugt von 0,1 bis 1 µm aufweist.

Demgemäß wird das oben beschriebene Grünkörpertrocknungsverfahren für das Trocknen von Grünkörpern, umfassend metallische und/oder keramische Nanopartikel und polymerisiertes Bindemittel verwendet. Erreichbare Vorteile wurden bereits geschildert.

Gemäß einer Ausführungsform wird vorgeschlagen, die Kritische-Punkt-Trocknung mit CO₂ vorzunehmen.

Die kritische Punkttrocknung mit CO₂ ist technisch vergleichsweise leicht zu bewerkstelligen. Kohlendioxid ist leicht zugänglich. Die Verwendung anderer Gase bzw. Flüssigkeiten wird jedoch nicht ausgeschlossen. Vorteilhaft werden diese dann vollständig im (geschlossenen) Kreislauf geführt bzw. nach abgeschlossener Trocknung zurückgewonnen und wiederholt verwendet.

Gemäß einer Ausführungsform ist der einer vorstehend beschriebenen Trocknung zu unterziehende Grünkörper unter Nutzung einer Zwei-Photonen-Polymerisation oder unter Nutzung einer Mehr-Photonen-Polymerisation eines Bindemittels zur Fixierung von zunächst kolloidal vorliegenden keramischen oder metallischen Nanopartikeln erzeugt worden. Als Nanopartikel kommen dabei die oben genannten Keramiken und Gläser, aber auch Metalle und deren Oxide in Betracht. Geeignete kolloidal mit polymerisierbarem Bindemittel vorliegende Metalle sind Gold, Silber, Eisenoxid, und andere anorganische Partikel, z.B. Quantenpunkte.

Wie bereits in den vorstehenden Absätzen ([0072] und [0074]) beschrieben, kombinieren feindispers suspendierte keramische Nanopartikel die Vorteile homogen verteilter und Agglomerations-freier Kolloide sowie die optische Transparenz bei der eingesetzten Wellenlänge, die für den Erfolg einer Zwei-Photonen-Polymerisation oder Mehr-Photonen-Polymerisation zum Erhalt von filigran strukturierten Grünkörpern förderlich sind.

Das vorgeschlagene Grünkörpertrocknungsverfahren ist Bestandteil eines laserbasierten Additivverfahrens zur Herstellung eines filigrane Strukturen aufweisenden Bauteils, das - beispielsweise - aus und in einem Kolloid generiert wird, das nanopartikuläres Zirkoniumoxid - hier als nano-ZrO₂ - bezeichnet, enthält.

Zusammenfassend wird also ein Additivverfahren zur Fertigung eines filigranen, aus keramischen oder metallischen Nanopartikeln aufgebauten Bauteils vorgeschlagen, das die folgenden Schritte umfasst:
- Bereitstellen eines Arbeitsvolumens eines Kolloids, umfassend kolloidal dispergierte Keramikpartikel eines Durchmessers von 3 bis 100 nm, bevorzugt von 3 bis 80 nm, besonders bevorzugt von 3 bis 35 nm, wobei das Kolloid
   0,05 - 20 Gew.-% eines Mehr-Photonenpolymerisationsinitiators,
   10 - 30 Gew.-% polymerisierbares Bindemittel, und
   30 - 90 Gew.-% Keramikpartikel, bezogen auf das Gesamtgewicht des Kolloids.umfasst;
- Führen eines Laserfokus im Arbeitsvolumen gemäß eines mit einer Slicing-Software erstellten Datensatzes, der das betreffende filigrane Keramikbauteil repräsentiert;
- lokales Polymerisieren des polymerisierbaren Bindemittels im Laserfokus, wobei das Führen des Laserfokus ein Ausbilden eines Grünkörpers in dem bereitgestellten Arbeitsvolumen bewirkt;
- Waschen des Grünkörpers in einer Waschflüssigkeit ausgewählt unter Wasser, einem organischen Lösemittel oder einer Mischung daraus;
- Austauschen der Waschflüssigkeit durch eine Austauschflüssigkeit, wobei das Austauschen optional eine kontinuierliche oder eine diskontinuierliche Steigerung einer Konzentration der Austauschflüssigkeit bei einer korrespondierenden Verringerung der Konzentration der Waschflüssigkeit umfasst, bis die Waschflüssigkeit durch die Austauschflüssigkeit ersetzt ist;
- Ersetzen der Austauschflüssigkeit durch wasserfreies flüssiges CO₂, wobei das Ersetzen mindestens 10 Mal, bevorzugt mindestens 15 Mal, weiter bevorzugt mindestens 18 Mal erfolgt indem ein zunächst verwendetes Volumen des wasserfreien flüssigen CO₂ durch ein identisches Volumen von wasserfreiem flüssigen CO₂ ersetzt wird, wobei der Grünkörper im wasserfreien flüssigen CO₂ in einem temperierbaren und druckstabilen Behälter angeordnet ist;
- Trocknen des in dem wasserfreien flüssigen CO₂ vorliegenden Grünkörpers mittels einer Kritischen-Punkt-Trocknung;
- Entbindern des getrockneten Grünkörpers durch eine thermische Behandlung; und
- Sintern des Grünkörpers zum filigranen Keramikbauteil.

Vorteilhaft erlaubt das beschriebene Herstellungsverfahren die lasergestützte Ausbildung des gesamten Grünkörpers in einem einmalig bereitgestellten Arbeitsvolumen. Der in die Tiefe des Arbeitsvolumens, durch die Software gesteuert, eindringende Laserstrahl bewirkt in seinem Fokus eine lokale 2PP-gestützte Polymerisation des polymerisierbaren Bindemittels. Dadurch werden lokal die kolloidal vorliegenden Keramikpartikel zuverlässig fixiert, sodass im Laserfokus jeweils ein Bestandteil des Grünkörpers ausgebildet wird. Der von der Slicing-Software in x-, y- und z-Richtung geführte Laserfokus hat somit nach vollständigem Durchlauf des Steuerprogramms die vollständige Ausbildung des Grünkörpers im einmal bereitgestellten Arbeitsvolumen bewirkt. Dabei kann der Grünkörper beispielsweise auf einer im Arbeitsvolumen starr fixierten Arbeitsplattform ruhen oder auf jener direkt aufgebaut werden. Eine in z-Richtung bewegliche Arbeitsplattform ist nicht erforderlich.

Alle in der Beschreibung beschriebenen Merkmale und/oder in den Ansprüchen beanspruchten Merkmale und/oder in den Zeichnungen dargestellten Merkmale können im Rahmen der Erfindung beliebig miteinander kombiniert werden. Wenngleich also hierin spezifische Ausführungsformen dargestellt und beschrieben worden sind, liegt es im Rahmen der vorliegenden Erfindung, die gezeigten Ausführungsformen geeignet zu modifizieren, ohne vom Schutzbereich der vorliegenden Erfindung abzuweichen. Die nachfolgenden Ansprüche stellen einen ersten, nicht bindenden Versuch dar, die Erfindung allgemein zu definieren.

## Patentansprüche

1. Additivverfahren zur Herstellung eines filigranen Keramikbauteils umfassend:
- Bereitstellen eines Arbeitsvolumens eines Kolloids, umfassend kolloidal dispergierte Keramikpartikel eines Durchmessers von 3 bis 100 nm, bevorzugt von 3 bis 80 nm, besonders bevorzugt von 3 bis 35 nm,
wobei das Kolloid
0,05 - 20 Gew.-% eines Mehr-Photonenpolymerisationsinitiators,
10 - 30 Gew.-% polymerisierbares Bindemittel, und
30 - 90 Gew.-% Keramikpartikel, bezogen auf das Gesamtgewicht des Kolloids.umfasst
- Führen eines Laserfokus im Arbeitsvolumen gemäß eines mit einer Slicing-Software erstellten Datensatzes, der das betreffende filigrane Keramikbauteil repräsentiert;
- lokales Polymerisieren des polymerisierbaren Bindemittels im Laserfokus, wobei das Führen des Laserfokus ein Ausbilden eines Grünkörpers in dem bereitgestellten Arbeitsvolumen bewirkt;
- Waschen des Grünkörpers in einer Waschflüssigkeit ausgewählt unter Wasser, einem organischen Lösemittel oder einer Mischung daraus;
- Austauschen der Waschflüssigkeit durch eine Austauschflüssigkeit, wobei das Austauschen eine kontinuierliche oder eine diskontinuierliche Steigerung einer Konzentration der Austauschflüssigkeit bei einer korrespondierenden Verringerung der Konzentration der Waschflüssigkeit umfasst, bis die Waschflüssigkeit durch die Austauschflüssigkeit ersetzt ist;
- Ersetzen der Austauschflüssigkeit durch wasserfreies flüssiges CO₂, wobei das Ersetzen mindestens 10 Mal, bevorzugt mindestens 15 Mal, weiter bevorzugt mindestens 18 Mal erfolgt indem ein zunächst verwendetes Volumen des wasserfreien flüssigen CO₂ durch ein identisches Volumen von wasserfreiem flüssigen CO₂ ersetzt wird, wobei der Grünkörper im wasserfreien flüssigen CO₂ in einem temperierbaren und druckstabilen Behälter angeordnet ist;
- Trocknen des in dem wasserfreien flüssigen CO₂ vorliegenden Grünkörpers mittels einer Kritischen-Punkt-Trocknung;
- Entbindern des getrockneten Grünkörpers durch eine thermische Behandlung; und
- Sintern des Grünkörpers zum filigranen Keramikbauteil.

2. Additivverfahren nach Anspruch 1,
wobei beim Trocknen das wasserfreie flüssige CO₂ mittels einer Steigerung eines Drucks und einer Temperatur in ein superkritisches CO₂ überführt wird und daran anschließend gasförmiges CO₂ kontrolliert aus dem temperierbaren und druckstabilen Behälter abgeführt wird.

3. Additivverfahren nach Anspruch 2,
wobei vor Abschluss der Kritischen-Punkt-Trocknung ein Druckabfall an einem Gasauslass des temperierbaren und druckstabilen Behälters 0,05 bar/sec nicht übersteigt.

4. Additivverfahren nach einem der Ansprüche 1-3,
wobei das Austauschen diskontinuierlich mittels einer Verdünnungsreihe umfassend mindestens 5 Austauschschritte mit verschiedenen Volumenverhältnissen der Waschflüssigkeit zu der Austauschflüssigkeit, beispielsweise in Verhältnissen von (v/v) 80:20, 60:40, 40:60, 20:80, 0:100 erfolgt, wobei die eingesetzten Verhältnisse von den angegebenen Werten abweichen können, beispielsweise um ± 5 oder um ± 10, mit der Maßgabe, dass die Summe von Anteilen der Waschflüssigkeit und der Austauschflüssigkeit jeweils 100 % ergibt.

5. Additivverfahren nach Anspruch 1 bis 4, wobei die Waschflüssigkeit kontinuierlich durch die Austauschflüssigkeit ersetzt wird, indem eine Konzentration der Austauschflüssigkeit kontinuierlich bis auf 100 vol-% ansteigt.

6. Additivverfahren nach einem der vorstehenden Ansprüche, wobei Austauschflüssigkeit zumindest teilweise als Waschflüssigkeit dient und/oder diese zumindest teilweise ersetzt.

7. Additivverfahren nach einem der vorstehenden Ansprüche, wobei der Grünkörper keramische Nanopartikel umfasst, die einen Durchmesser im Bereich von 3 bis 150 nm aufweisen, bevorzugt von 3 bis 100 nm, weiter bevorzugt von 3 bis 80 nm, besonders bevorzugt von 3 bis 35 nm aufweisen.

8. Additivverfahren nach Anspruch 7, wobei die keramischen Nanopartikel ausgewählt sind aus der Gruppe bestehend aus: Aluminiumoxid (Al₂O₃); Siliziumdioxid (SiO₂); Natriumoxid (Na₂O), Calciumoxid (CaO); Phosphorpentoxid (P₂O₅); einem Bioglas; beta-Tricalciumphosphat (B-TCP); einer aluminiumoxidverstärkten Zirkonoxidkeramik (ATZ); Titannitrid (TiN); Calciumcarbonat (CaCO₃); einer Lithium-Disilikat-Glaskeramik; AP40 Glas; einem yttriumoxidstabilisiertem Zirkonoxid (YSZ); einem mesoporösen bioaktiven Glas (MGB); Ceriumoxid (CeO₂); Zinkoxid (ZnO); Zirkonoxid (ZrO₂); Hydroxylapatit (HA); biphasischem Calciumphosphat (BCP); und Blei-Zirkonat-Titanat (PZT).

9. Additivverfahren nach einem der vorstehenden Ansprüche, wobei die Austauschflüssigkeit ausgewählt ist unter einem Keton und einem Alkohol, insbesondere unter Aceton, Ethanol und iso-Propanol.

10. Verwendung einer Kritischen-Punkt-Trocknung in einem Additivverfahren zur Herstellung eines filigranen Keramikbauteils gemäß einem der Ansprüche 1-9 für das Trocknen des dabei erhaltenen keramischen Grünkörpers, umfassend ein polymerisiertes Bindemittel und keramische Nanopartikel, wobei der keramische Grünkörper zumindest eine Struktur umfasst, die eine lineare Ausdehnung ≤ 10 µm, vorzugsweise von 1 - 5 µm, besonders bevorzugt von 0,1-1 µm aufweist.

11. Verwendung nach Anspruch 10, wobei die Kritische-Punkt-Trocknung mit CO₂ erfolgt.

12. Verwendung nach Anspruch 10 oder 11, wobei der keramische Grünkörper unter Nutzung einer Zwei-Photonen-Polymerisation oder einer Mehr-Photonen-Polymerisation eines Bindemittels aus kolloidal vorliegenden keramischen, metallischen, wie Gold, Silber oder Eisenoxid, oder anderen anorganischen Partikeln, wie Quantum Dots erhalten wurde.
